# FASCICULE DE BREVET EUROPEEN

(11) **EP 2 316 785 B1**
(45) Date de publication et mention de la délivrance du brevet: **09.01.2013**
(21) Numéro de dépôt: 10189290.9
(22) Date de dépôt: 28.10.2010
(51) Int. Cl.: B81B 7/00, H05K 3/40, H01L 23/48, H01L 23/498

(54) **Structure d'interconnexion à cavité présentant une ou plusieurs remontées de contact sur les parois de la cavité et son procédé de réalisation**
Hohlraumverbindungsstruktur, die eine oder mehrere aufsteigende Leiter an den Wänden des Hohlraums aufweist und deren Herstellungsverfahren
Interconnection structure in a cavity having one or more contact rises on the walls of the cavity and manufacturing method thereof

(30) Priorité: 28.10.2009 FR 0957588
(43) Date de publication de la demande: 04.05.2011
(73) Titulaire: Commissariat à l'Énergie Atomique et aux Énergies Alternatives, 75015 Paris (FR)
(72) Inventeur: Bolis, Sébastien, 38920, CROLLES (FR); Jacquet, Fabrice, 38220, SAINT PIERRE DE MESAGE (FR); Saint-Patrice, Damien, 26120, CHABEUIL (FR)
(74) Mandataire: Ilgart, Jean-Christophe

(56) Documents cités:
- US-A- 5 825 084
- US-A- 5 994 763
- US-A1- 2003 224 559
- PHAM NGA P ET AL: "Spin, spray coating and electrodeposition of photoresist for MEMS - a comparison", Delft University of Technology, DIMES , 1 janvier 2000 (2000-01-01), XP007916419, Extrait de l'Internet: URL:http://citeseerx.ist.psu.edu/viewdoc/d ownload?doi=10.1.1.9.8031&rep=rep1&type=pd f [extrait le 2010-12-15]

## Description

### DOMAINE TECHNIQUE

La présente invention concerne le domaine de la microélectronique et des microsystèmes, et plus particulièrement celui des structures d'interconnexions notamment réalisées lors d'étapes communément appelées de « waferlevel packaging » (WLP), c'est-à-dire des étapes de fabrication de boîtiers de circuits intégrés réalisées sur un wafer avant découpe en circuits élémentaires.

Elle prévoit une structure d'interconnexion améliorée avec une ou plusieurs remontées de contact dans une cavité formée dans un support afin de connecter entre eux des éléments situés de part et d'autre du support, ainsi qu'un procédé de réalisation d'une telle structure.

### ART ANTERIEUR

Le document « Spin, Spray coating and Electrodeposition of photoresist for MEMS structures - A comparison », Pham et al., Delft University of Technology, DIMES, présente des structures d'interconnexion comportant une remontée de contact réalisée sur des parois inclinées d'une cavité, avec un élément conducteur permettant d'établir un contact entre une zone conductrice située dans la cavité et un autre élément situé au dessus de la cavité.

La réalisation de remontées de contacts pose problème lorsque les parois de la cavité sont verticales.

La demande de brevet publiée US 2003/224559 A1 divulgue un dispositif d'interconnexion formé de deux substrats superposés. Le dispositif comporte un trou formé d'une cavité qui présente une première ouverture réalisée dans le premier substrat et une deuxième ouverture de section différente réalisée dans le deuxième substrat. Un élément conducteur est disposée sur une paroi du trou et traverse ceci.

Le document WO 01/45172 présente quant à lui un procédé de réalisation d'une structure d'interconnexion en trois dimensions que l'on forme en réalisant des rainures par sciage du bord d'un support, puis en déposant un matériau métallique dans ces rainures.

Les structures d'interconnexion ainsi formées sont nécessairement situées à proximité des bords du support.

Il se pose le problème de trouver une nouvelle structure d'interconnexion, qui ne présente pas les inconvénients mentionnés ci-dessus, qui soit plus aisée à mettre en oeuvre, ainsi qu'un procédé de réalisation d'une telle structure.

### EXPOSÉ DE L'INVENTION

L'invention concerne tout d'abord un dispositif d'interconnexion comprenant un support, formé de plusieurs substrats et/ou de plusieurs couches superposées, comportant au moins un trou, le trou ayant des parois formant un contour fermé et étant formé d'une cavité et d'une, ou plusieurs rainures communiquant avec ladite cavité, ladite cavité étant formée d'une première ouverture réalisée dans un premier substrat et/ou dans une première couche et d'une deuxième ouverture de section différente de la première ouverture réalisée dans un deuxième substrat et/ou dans une deuxième couche, les rainures s'étendant tout ou partie le long du trou, plusieurs éléments conducteurs étant disposés sur au moins une paroi du trou et traversant ce dernier, les éléments conducteurs étant destinés chacun à connecter entre elles des zones conductrices situées de part et d'autre du support et les rainures à assurer une discontinuité électrique entre les éléments conducteurs.

Selon une possibilité de mise en oeuvre, au moins une des dites rainures séparent entre eux deux desdits éléments conducteurs.

Selon une possibilité de mise en oeuvre, le dispositif peut comporter au moins un élément conducteur logé dans une desdites rainures et s'étendant le long de ladite rainure.

La cavité peut traverser l'épaisseur du support.

Selon une variante, la cavité peut être formée d'un orifice borgne'réalisé dans le support.

Les rainures peuvent communiquer avec ladite première ouverture, une ou plusieurs autres rainures formées dans le deuxième substrat le long de la cavité formée dans ledit substrat communiquant avec la deuxième ouverture.

Les parois de la cavité peuvent être recouvertes de matériau conducteur. On peut ainsi former une protection contre des perturbations électromagnétiques sur le pourtour de la cavité.

L'invention concerne également un procédé de réalisation d'un dispositif d'interconnexion tel que défini plus haut, et comprenant les étapes consistant à :
- former des plots conducteurs traversant un support,
- former une cavité dans l'épaisseur du support de manière à entamer et retirer une partie des plots conducteurs, l'autre partie des plots étant conservée et formant des éléments conducteurs logés dans des rainures.

L'invention concerne également un procédé de réalisation d'un dispositif d'interconnexion tel que défini plus haut, le procédé comprenant les étapes consistant à :
- former une cavité dans l'épaisseur d'un support,
- former une zone à base de matériau conducteur recouvrant les parois de la cavité,
- former au moins une rainure de manière à entamer le matériau conducteur, la rainure communiquant avec la cavité.

L'invention concerne également un procédé de réalisation d'un dispositif d'interconnexion tel que défini plus haut, le procédé comprenant les étapes consistant à :
- former une cavité dans l'épaisseur d'un support et des rainures communiquant avec ladite cavité et s'étendant sur tout ou partie de celle-ci,
- former une couche de matériau sacrificiel dans les rainures, de manière à séparer les rainures de la cavité,
- former une couche conductrice sur les parois de la cavité,
- retirer la couche de matériau sacrificiel de manière à retirer des portions de la couche conductrice entre les rainures et la cavité.

L'invention concerne également un procédé de réalisation d'un dispositif d'interconnexion tel que défini plus haut, comprenant les étapes consistant à :
- former une cavité dans l'épaisseur du support,
- former au moins une rainure communiquant avec ladite cavité et s'étendant sur tout ou partie de celle-ci, ladite rainure étant réalisée de sorte qu'elle présente, dans un plan parallèle au support, une section variable avec un rétrécissement au niveau de la communication entre la rainure et la cavité,
- réaliser un dépôt directionnel de matériau conducteur sur ladite paroi et sur une partie de la rainure.

Dans le cas où le support comporte plusieurs substrats ou couches, chacun des procédés ci-dessus peut être mis en oeuvre pour chaque substrat ou chaque couche.

Les différents substrats ou les différentes couches peuvent ensuite être assemblées pour former le support final.

On peut aussi réaliser l'assemblage de différents substrats ou de différentes couches avant de mettre en oeuvre l'un des procédés ci-dessus, en particulier dans le cas où le support comporte seulement deux substrats ou couches.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
- les figures 1A-1B illustrent un premier exemple de structure d'interconnexion suivant l'invention, dotée d'une remontée de contact réalisée dans une cavité,
- la figure 2 illustre un deuxième exemple de structure d'interconnexion suivant l'invention, comportant des éléments conducteurs traversant une cavité et qui sont isolés électriquement entre eux par l'intermédiaire de tranchées communiquant dans la cavité,
- les figures 3A-3B illustrent un troisième exemple de structure d'interconnexion suivant l'invention, dotée d'une cavité et de rainures dans lesquelles passent des éléments de connexion,
- les figures 4A-4B illustrent un quatrième exemple de structure d'interconnexion suivant l'invention, dotée de remontées de contact traversant une cavité et isolées entre elles par des rainures formées le long de la cavité dans lesquelles sont prévus des éléments de connexion,
- la figure 5 illustre un cinquième exemple de structure d'interconnexion suivant l'invention,
- la figure 6 illustre un sixième exemple de structure d'interconnexion suivant l'invention, dans lequel des remontées de contact sont formées tout autour d'une cavité,
- la figure 7 illustre un septième exemple de structure d'interconnexion suivant l'invention dotée d'une cavité tapissée d'une zone de matériau conducteur isolée d'un élément conducteur traversant la cavité par l'intermédiaire de rainures formées contre les parois de la cavité,
- les figures 8A-8C illustrent un exemple de support formé de deux substrats superposés dans lesquels sont formées des cavités,
- les figures 9A-9B illustrent un autre exemple de structure d'interconnexion suivant l'invention, formée dans une cavité en plusieurs parties de sections différentes, chaque partie comportant des zones conductrices isolées entre elles par des rainures réalisées le long des parois de la cavité, des rainures formées dans une partie de la cavité communiquant par l'intermédiaire de tranchées avec d'autres rainures formées dans une autre partie,
- les figures 10A-10B illustrent un autre exemple de structure d'interconnexion suivant l'invention, formée dans une cavité en plusieurs parties de sections différentes, chaque partie comportant des zones conductrices isolées entre elles par des rainures réalisées le long des parois de la cavité,
- les figures 11A-11B illustrent un autre exemple de structure d'interconnexion suivant l'invention, formée dans une cavité borgne,
- les figures 12A-12B illustrent un autre exemple de structure d'interconnexion suivant l'invention, réalisée dans une cavité borgne, des remontées de contact étant prévues sur tout le pourtour de la cavité,
- la figure 13 illustre un exemple de structure d'interconnexion suivant l'invention, formée dans une cavité borgne et connectée à des vias d'interconnexion débouchant au fond de la cavité borgne,
- la figure 14 illustre une variante de l'exemple de structure d'interconnexion donnée sur la figure 13,
- les figures 15 à 17 illustrent un autre exemple de structure d'interconnexion suivant l'invention à cavité borgne réalisée dans un support sous forme de deux substrats superposés entre lesquels est prévu un film conducteur anisotrope,
- les figures 18A-18B illustrent une réalisation d'une cavité dans un support dans le cadre de la mise en oeuvre d'une structure d'interconnexion suivant l'invention,
- les figures 19A-19B illustrent une réalisation d'une structure d'interconnexion suivant l'invention,
- les figures 20 et 21 illustrent un support formé de deux substrats assemblés par collage dans lequel une cavité est réalisée,
- les figures 22A-22C illustrent un exemple de procédé de réalisation d'une structure d'interconnexion suivant l'invention,
- les figures 23A-23B illustrent un autre exemple de procédé de réalisation d'une structure d'interconnexion suivant l'invention,
- les figures 24A-24B illustrent un autre exemple de procédé de réalisation d'une structure d'interconnexion suivant l'invention,
- les figures 25A-25D illustrent un autre exemple de procédé de réalisation d'une structure d'interconnexion suivant l'invention,
- les figures 26 et 27 illustrent un autre exemple de procédé de réalisation d'une structure d'interconnexion suivant l'invention,
- les figures 28A-28B, 29A-29B, 30A-30E illustrent un exemple de procédé de réalisation d'une structure d'interconnexion à remontée de contact dans une cavité et l'intégration d'une telle structure dans un dispositif imageur,
- la figure 31 illustre un exemple de dispositif MEMS doté d'une cavité dans laquelle une structure d'interconnexion suivant l'invention peut être formée,
- la figure 32 illustre un exemple de dispositif optique doté d'une cavité dans laquelle une structure d'interconnexion suivant l'invention peut être formée,
- les figures 33A-33B illustrent un exemple de réalisation de tranchées horizontales.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

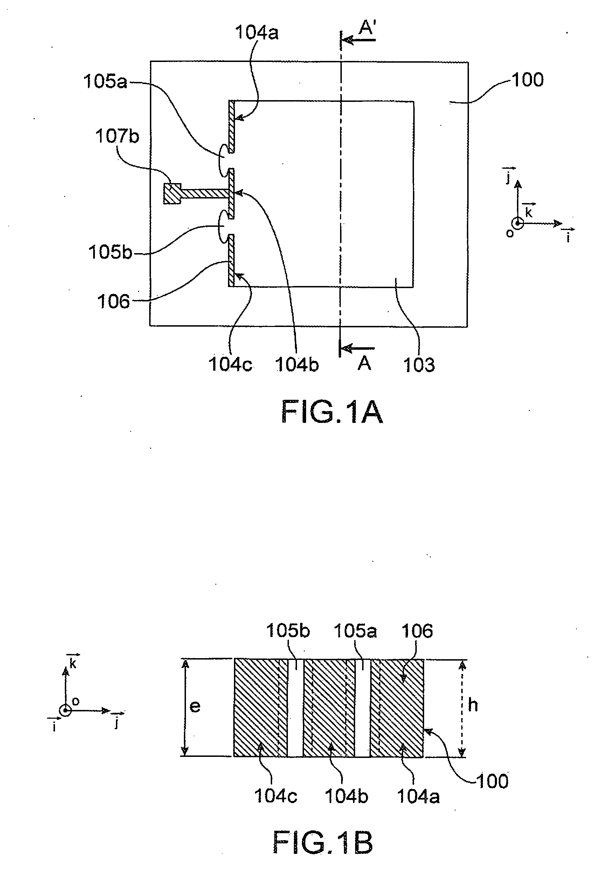

Un premier exemple de structure d'interconnexion mise en oeuvre suivant l'invention, est donné sur les figures 1A-1B (la figure 1A représentant la structure selon une vue de dessus tandis que la figure 1B illustre cette structure selon une vue en coupe transversale, le plan de coupe étant indiqué sur la figure 1A).

La structure est réalisée dans un support 100 qui peut être par exemple sous forme d'une couche, ou d'un empilement de plusieurs couches, ou d'un substrat, ou d'un empilement de plusieurs substrats, ou d'un interposeur, et comporte une cavité 103 traversant l'épaisseur du support entre sa face supérieure (représentée sur la figure 1A) et sa face inférieure.

Le support 100 peut être par exemple en matériau semi-conducteur, ou en matériau isolant, par exemple en verre.

La structure d'interconnexion permet de connecter des éléments ou des dispositifs situés de part et d'autre de la face inférieure et de la face supérieure du support. La structure d'interconnexion peut être éventuellement réalisée dans une zone centrale du support.

Une paroi verticale de la cavité 103 est recouverte d'éléments 104a, 104b, 104c, à base d'un matériau conducteur 106 tel que par exemple du cuivre, de l'aluminium, ou du tungstène ou du polysilicium.

Les éléments conducteurs 104a et 104b, peuvent être sous forme de plaques tapissant une paroi verticale de la cavité 103 (la direction verticale étant définie comme une direction parallèle au vecteur k du repère orthogonal [o;*i̅*;*j̅*;*k̅*] donné sur les figures).

Les éléments conducteurs 104a, 104b, sont séparés entre eux par l'intermédiaire d'une rainure 105a communiquant avec la cavité 103 et formée au niveau de ladite paroi verticale, tandis qu'une autre rainure 105b sépare les éléments conducteurs 104b et 104c. Ces rainures 105a, 105b s'étendent dans la direction verticale et traversent l'épaisseur e du support 100 qui, dans cet exemple, correspond à la hauteur h de la cavité 103.

Les rainures 105a, 105b et la cavité 103 communicant avec ces dernières forment un trou dont les parois verticales réalisent un contour fermé.

Les rainures 105a, 105b et la cavité 103 peuvent avoir été réalisées simultanément ou successivement, par exemple par gravure telle qu'une gravure DRIE (DRIE pour « Deep reactive ion etching ») ou une gravure laser.

Les rainures 105a, 105b permettent d'assurer une discontinuité électrique entre les éléments conducteurs 104a, 104b, 104c.

Ainsi, les éléments conducteurs 104a, 104b, 104c ne sont pas connectés entre eux ou reliés électriquement entre eux.

Dans cet exemple, un des éléments conducteurs 104b est prolongé par une piste conductrice 107b qui s'étend sur la face supérieure du support 100 parallèle au plan principal de ce dernier (le plan principal du support étant défini comme un plan passant par ce dernier et parallèle au plan [o;*i̅*;*j̅*] donné sur les figures).

Les éléments conducteurs 104a, 104b, 104c traversant permettent chacun de connecter un dispositif situé sur ou au dessus de la face supérieure du support 100 et un autre dispositif situé sous ou au dessous de la face inférieure du support 100.

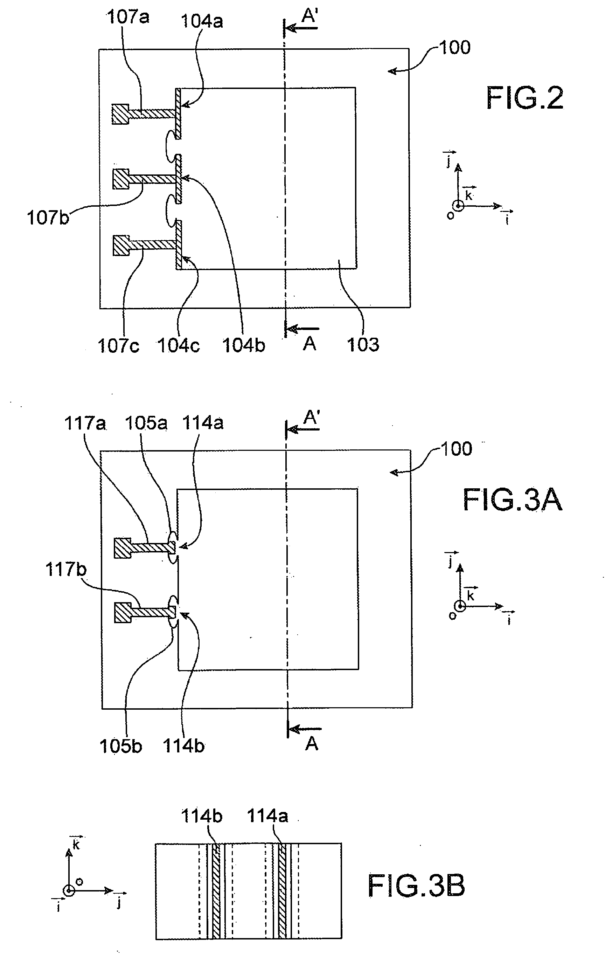

Selon une variante (figure 2), les éléments conducteurs 104a, 104b, 104c, peuvent être prolongés respectivement par des pistes conductrices 107a, 107b, 107c, qui s'étendent sur la face supérieure du support 100.

Un autre exemple de structure d'interconnexion est donné sur les figures 3A-3B.

Dans cet autre exemple, des éléments 114a, 114b, de connexion verticaux à base de matériau conducteur sous forme de lignes conductrices sont en outre disposés dans les rainures 105a, 105b, et traversent l'épaisseur du support 100. Les éléments 114a, 114b, tout comme les rainures 105a, 105b réalisent un angle non nul par rapport au plan principal du support, et sont, dans cet exemple, perpendiculaires au plan principal du support.

Les éléments 114a, 114b, de connexion ne recouvrent qu'une portion des parois des rainures 105a, 105b.

Les éléments de connexion 114a, 114b, sont prolongés respectivement par des pistes conductrices 117a, 117b, qui s'étendent sur la face supérieure du support 100.

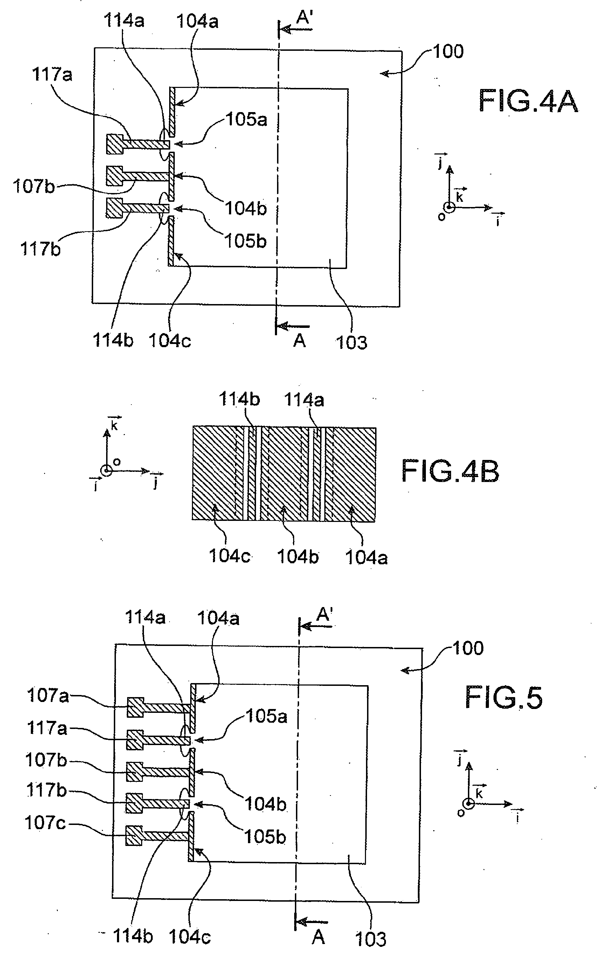

Dans l'exemple donné sur les figures 4A-4B, la structure comporte des éléments conducteurs 104a, 104b, 104c sur une paroi de la cavité 103 et des éléments de connexion 114a, 114b dans les rainures, les éléments de connexion 114a, 114b dans les rainures sont reliés à des pistes conductrices 117a, 117b, qui s'étendent sur la face supérieure du support, tandis que l'élément conducteur 104b est également relié à une piste 107b reposant sur le support.

Les éléments 114a, 114b, de connexion ne recouvrent qu'une portion des rainures 105a, 105b, ces dernières permettant d'assurer une discontinuité électrique entre les éléments 114a, 114b, de connexion et les éléments conducteurs 104a, 104b, 104c. Les rainures 105a, 105b permettent de séparer et d'isoler électriquement les éléments de connexion 104a, 104b, 104c, des éléments conducteurs 114a, 114b.

Sur l'exemple de la figure 5, par rapport à l'exemple précédemment décrit, les éléments conducteurs 104a, 104c, sont en outre reliés respectivement aux pistes conductrices 107a, 107c, disposées sur la face supérieure du support 100.

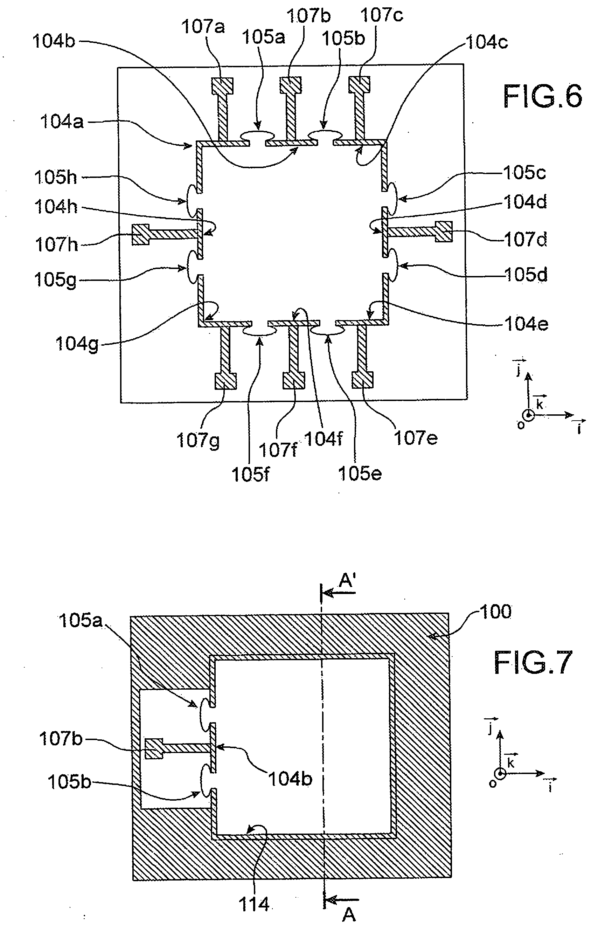

Un exemple de structure avec une cavité 103 dont les parois verticales sont chacune recouvertes d'éléments conducteurs, les éléments conducteurs 104a, 104b, 104c, 104d, 104e, 104f, 104g, 104h étant séparés par une succession de rainures 105a, 105b, 105c, 105d, 105e, 105f, 105g, 105h, formées tout autour de la cavité 103 est donné figure 6.

Un autre exemple de structure d'interconnexion formée dans une cavité 103 est illustré sur la figure 7. Dans cet exemple, les parois verticales de la cavité 103 sont entièrement tapissées par une zone conductrice 114, qui recouvre également une partie de la face supérieure du support 100.

Un élément de connexion 104b formé sur une paroi verticale de la cavité 103 est séparé et déconnecté de la zone conductrice 114 par l'intermédiaire des rainures 105a, 105b verticales communiquant avec la cavité 103.

L'élément de connexion 104b est prolongé par une piste conductrice 107b qui s'étend sur la face supérieure du support 100.

Une zone du support qui n'est pas recouverte de matériau conducteur, sépare la piste conductrice 107b de la zone conductrice 114, de sorte que la zone conductrice 114 et la piste conductrice 107b ne sont pas reliées électriquement.

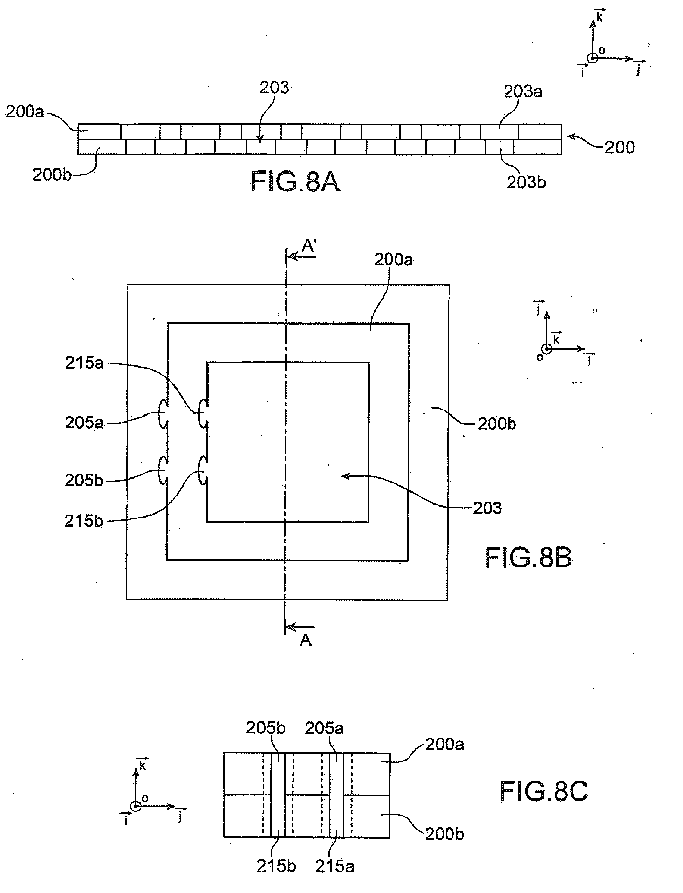

Comme cela est illustré sur les figures 8A-8C (la figure 8B illustrant le dispositif selon une vue de dessus tandis que les figures 8A et 8C représentent des vues en coupe transversale) une structure d'interconnexion suivant l'invention peut être réalisée dans une cavité 203 formée de plusieurs parties 203a, 203b de dimensions différentes dans l'épaisseur d'un support 200.

La ou les cavités 203 peut ou peuvent être formé(es) d'une première partie 203a, ayant des dimensions données et d'une deuxième partie 203b située dans le prolongement de la première partie, la deuxième partie 203b ayant dans un plan parallèle au support, des dimensions plus faibles que la première partie 203a, la première partie 203a et la deuxième partie 203b étant délimitées par des parois formant un profil en escaliers. La configuration en escalier peut permettre par exemple de loger une lentille dans la première partie 203a et de la positionner par rapport à un imageur à l'aide de la deuxième partie 203b tout en permettant une remontée de contacts électriques le long de la cavité en escaliers.

Selon une possibilité de mise en oeuvre, un profil en escaliers comportant un nombre de marches supérieur à 2, peut être mis en oeuvre.

Le support 200 peut être éventuellement formé de plusieurs couches ou de plusieurs substrats empilés, par exemple deux couches 200a, 200b ou de deux substrats 200a, 200b, qui peuvent être assemblés par exemple par collage.

Pour cela un cordon 211 de colle peut être par exemple prévu entre les deux substrats 200a, 200b.

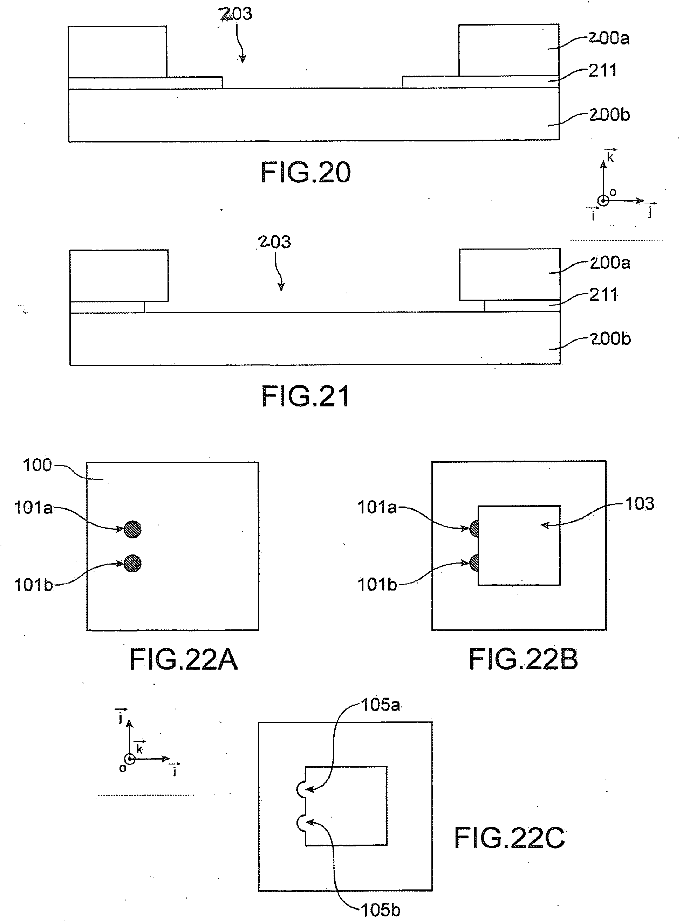

Ce cordon 211 de colle peut être, selon un premier cas, formé de manière à parvenir dans la cavité 203 (figure 20) ou de manière à être disposé en retrait par rapport aux parois de la cavité 203 (figure 21).

Le premier substrat 200a comporte des rainures 205a, 205b, verticales communiquant avec la première partie 203a de la cavité 203 et formées dans une paroi de cette première partie 200a, tandis que le deuxième substrat 200b comporte des rainures 215a, 215b verticales communiquant avec la deuxième partie 203b de la cavité 203 et formées dans une paroi de cette deuxième partie 203b.

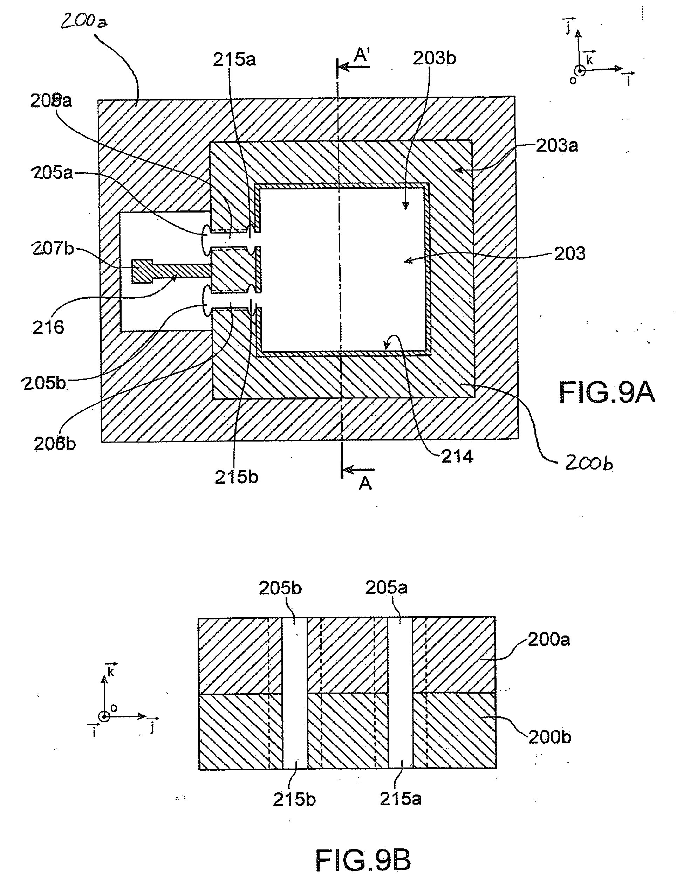

Sur les figures 9A-9B, un exemple de structure d'interconnexion muni d'un support dans lequel une telle cavité 203 est formée, est donné.

Dans cette structure, une première zone conductrice 214 recouvre une portion de la face supérieure du premier substrat 200a, une partie des parois verticales de la première partie 203a de la cavité 203, une portion de la face supérieure du deuxième substrat 200b située au fond de cette première partie 203a, ainsi qu'une portion des parois verticales de la deuxième partie 203b de la cavité 203.

Une deuxième zone conductrice 216, distincte de la première zone conductrice 214, est formée d'une bande conductrice 207b s'étendant sur la face supérieure du premier substrat 200a, prolongée en une portion recouvrant une paroi verticale de la première partie 203a de la cavité, une portion de la face supérieure du deuxième substrat 200b située au fond de cette première partie 203a, ainsi qu'une portion des parois verticales de la deuxième partie 203b de la cavité 203.

La première zone conductrice 214 et la deuxième zone conductrice 216 sont séparées et isolées électriquement l'une de l'autre par l'intermédiaire de rainures 205a, 205b verticales formées dans le premier substrat 200a, de tranchées horizontales 208a, 208b (la direction horizontale étant définie comme une direction parallèle au plan [o;*i̅*;*j̅*] du repère orthogonal [o;*i̅*;*j̅*;*k̅*] donné sur les figures) formées sur le deuxième substrat 200b et communiquant avec les rainures 205a, 205b, et de rainures 215a, 215b, verticales formées dans le deuxième substrat 200b. Les rainures 205a, 205b, 215a, 215b communiquent avec la cavité.

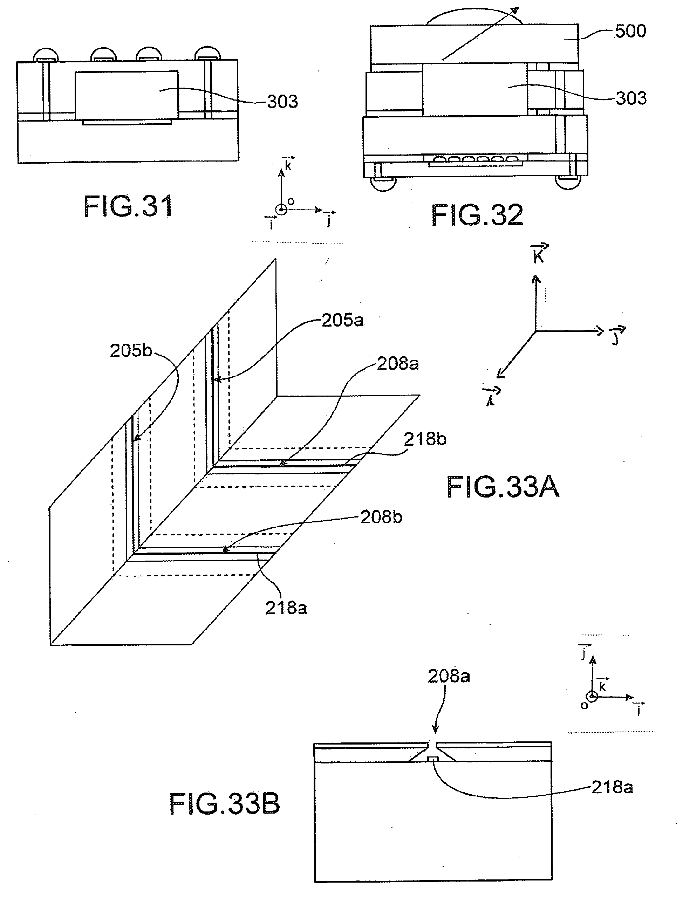

Un autre exemple de réalisation de tranchées horizontales 208a, 208b, est donné sur les figures 33A-33B (le support étant représenté sans zone conductrice sur la figure 33A).

Dans cet autre exemple, des zones conductrices 218a, 218b s'étendent le long des tranchées et comportent des zones conductrices qui s'étendent le long de ces dernières.

Les tranchées 208a, 208b, peuvent être formées de sorte que leur embouchure est moins large que leur fond.

Cela peut permettre de former des zones 218a, 218b conductrices qui ne recouvrent qu'une portion du fond des tranchées.

Ces zones 218a, 218b peuvent être en effet réalisées par dépôt de métal, le métal n'étant, par effet d'ombrage dû à la forme des tranchées 208a, 208b, déposé que sur une portion du fond des tranchées.

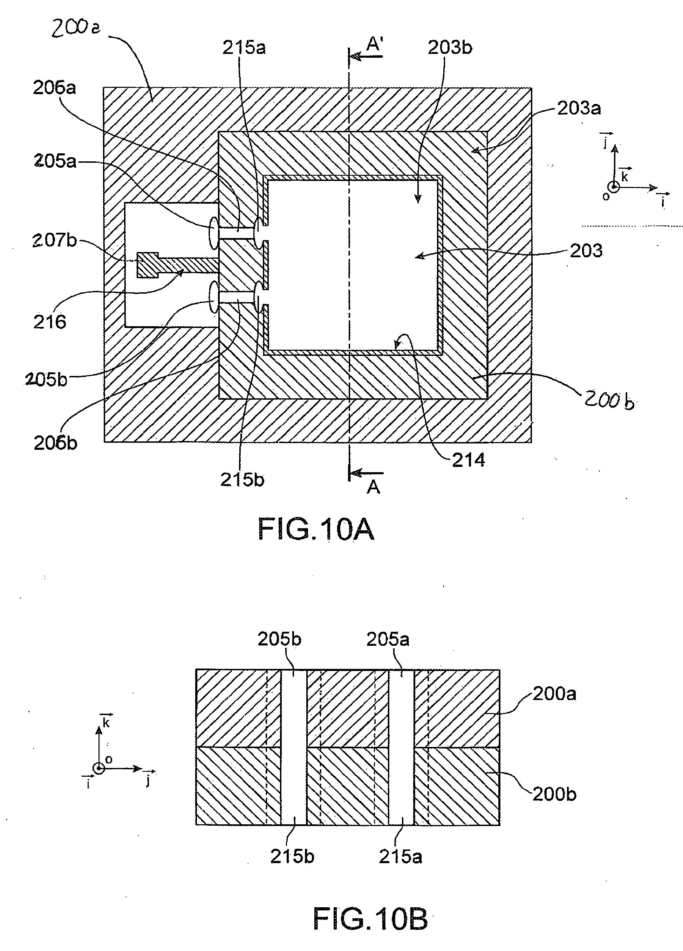

Selon une variante de l'exemple précédemment décrit (figures 10A-10B), les tranchées horizontales 208a, 208b, formées dans le deuxième substrat 200b, sont remplacées par des zones 206a, 206b du deuxième substrat 200b qui sont dévoilées et ne sont pas recouvertes de matériau conducteur.

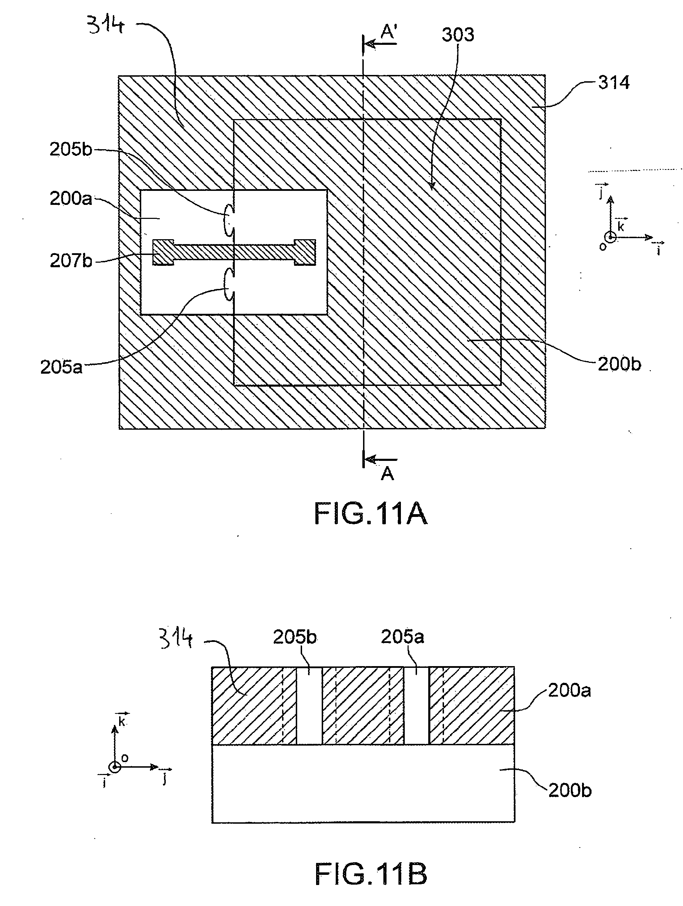

Une structure d'interconnexion avec une cavité 303 « borgne » peut être également prévue (figures 11A et 11B).

Dans ce cas, la cavité 303 peut être formée dans l'épaisseur d'un premier substrat 200a, reposant sur un deuxième substrat 200b, la cavité 303 traversant l'épaisseur du premier substrat 200a, et ayant un fond au niveau du deuxième substrat 200b et qui peut être formé par la face supérieure de ce dernier.

Une portion de la face supérieure du premier substrat 200a, une partie des parois de la cavité, ainsi que la face supérieure du deuxième substrat 200b sont recouvertes par une zone conductrice 314.

Une piste métallique 207b s'étend sur la face supérieure du premier substrat 200a, sur une paroi de la cavité 303, et sur la face supérieure du deuxième substrat 200b.

Cette piste métallique 207b est séparée et isolée électriquement de la zone conductrice 314 par l'intermédiaire de rainures 205a, 205b formées dans les parois de la cavité, ainsi que de zones des substrats 200a, 200b qui ne sont pas recouvertes de matériau métallique.

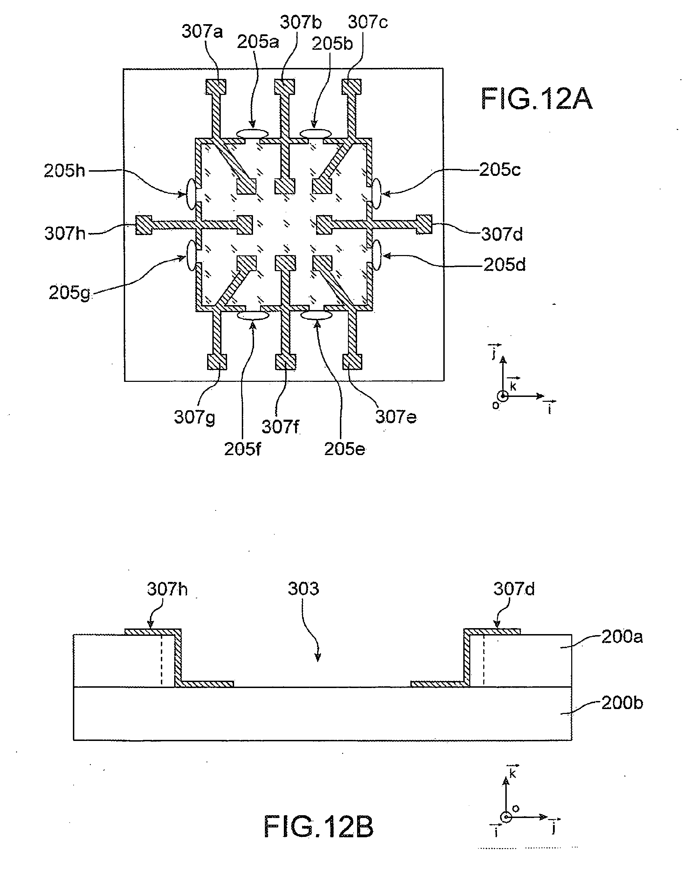

Un autre exemple de structure d'interconnexion avec une cavité borgne est donné sur les figures 12A-12B. Des rainures 205a, 205b, 205c, 205d, 205e, 205f, 205g, 205h, sont formées tout autour de la cavité et isolent électriquement entre eux des éléments conducteurs 307a, 307b, 307c, 307d, 307e, 307f, 307g, 307h, formés chacun d'une piste conductrice s'étendant sur le premier substrat 200a, d'une zone conductrice recouvrant une paroi de la cavité, et d'une autre piste conductrice s'étendant au fond de la cavité 303 sur le deuxième substrat 200b.

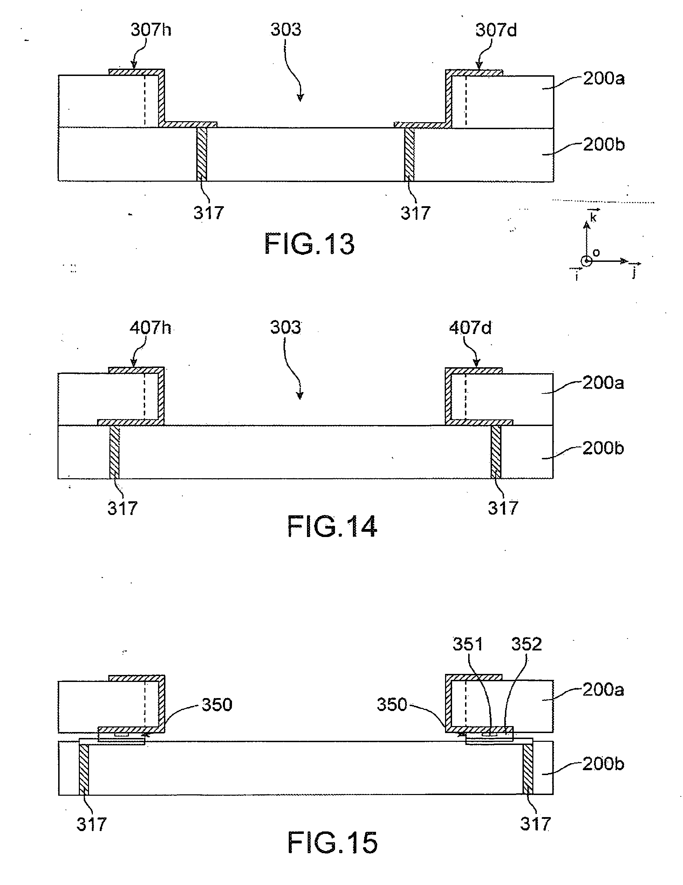

Selon une possibilité de mise en oeuvre, les éléments conducteurs 307a, 307b, 307c, 307d, 307e, 307f, 307g, 307h, peuvent être connectés à des vias 317 traversant le deuxième substrat 200b (figure 13).

Une variante de cette structure est donnée sur la figure 14 et prévoit des éléments conducteurs 407h, 407d formés chacun d'une bande conductrice s'étendant sur le premier substrat 200a, d'une zone conductrice recouvrant une paroi de la cavité, et d'une autre bande conductrice située entre le premier 200a et le deuxième substrat 200b, cette autre bande conductrice étant connectée à une via 317.

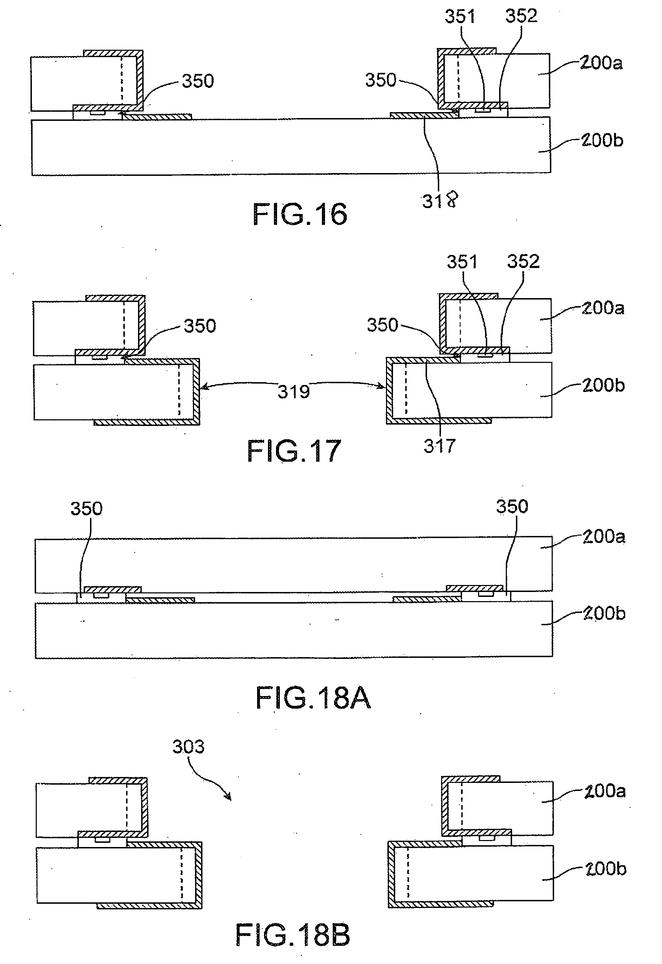

Dans les exemples de structures des figures 15, 16, 17, des zones d'interconnexion 350 formées de pistes métalliques 351 dans une couche de matériau diélectrique 352 sont prévues entre le premier substrat 200a et le deuxième substrat 200b, et permettent d'établir une connexion entre les éléments conducteurs 307h, 307d du premier substrat 200a et d'autres éléments conducteurs du deuxième substrat 200b, par exemple des vias 317 traversant le deuxième substrat 200b (figure 15) ou des zones métalliques 318 reposant sur le deuxième substrat 200b (figure 16) ou des zones métalliques 319 recouvrant des portions des deux faces du deuxième substrat 200b, ainsi que des parois d'une ouverture traversant le deuxième substrat 200b (figure 17).

Comme cela est illustré sur les figures 18A et 18B, la cavité de la structure d'interconnexion précédemment décrite peut être formée une fois que les substrats 200a et 200b ont été assemblés et connectés.

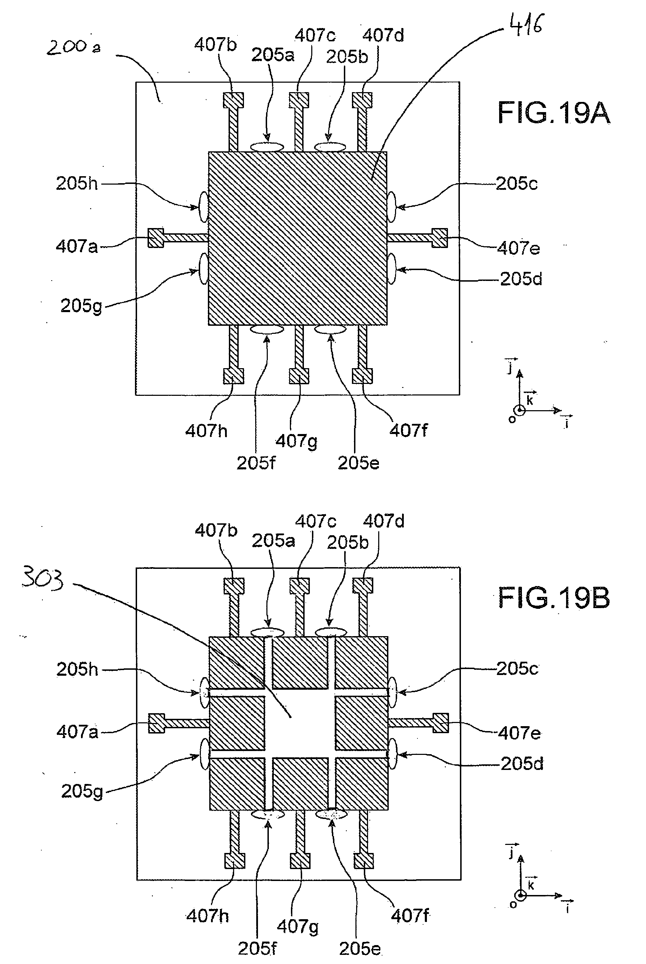

Les figures 19A-19B illustrent un exemple de réalisation d'une structure d'interconnexion dans lequel le fond et les parois d'une cavité 303 borgne sont recouverts d'une couche métallique 416 à laquelle des bandes métalliques 407a, 407b, 407c, 407d, 407e, 407f, 407g, 407h reposant sur le premier substrat 200a sont formées.

Des rainures 205a, 205b, 205c, 205d, 205e, 205f, 205g, 205h verticales formées tout autour de la cavité 303 et communicant avec cette dernière isolent entre elles des zones de la couche métallique dans une direction orthogonale au substrat (figure 19A).

Ensuite, des portions de la zone métallique 416 sont retirées au fond de la cavité 303.

Le retrait peut être effectué de telle sorte que la couche métallique 416 est retirée entre des rainures situées en vis-à-vis l'une de l'autre sur des parois opposées de la cavité 303.

Un exemple de procédé de réalisation d'une cavité dotée de rainures d'isolation telle que prévue dans une structure d'interconnexion suivant l'invention, est illustré sur les figures 22A-22C.

On forme tout d'abord des plots 101a, 101b dans l'épaisseur d'un support 100, qui peut être sous forme d'une couche ou d'un empilement de couches ou d'un substrat (figure 22A).

Les plots 101a, 101b peuvent être des plots conducteurs par exemple à base d'un matériau métallique tel que du cuivre, de l'aluminium ou du tungstène ou du polysilicium. Ces plots peuvent être des vias isolés par l'intermédiaire d'une épaisseur de matériau diélectrique les entourant.

Puis, on forme une cavité 103 traversant le support 100.

La cavité 103 est réalisée de manière à traverser une portion du support où se situe une partie des plots conducteurs 101a, 101b, et ainsi à entamer et retirer une portion des plots conducteurs 101a, 101b (figure 22B).

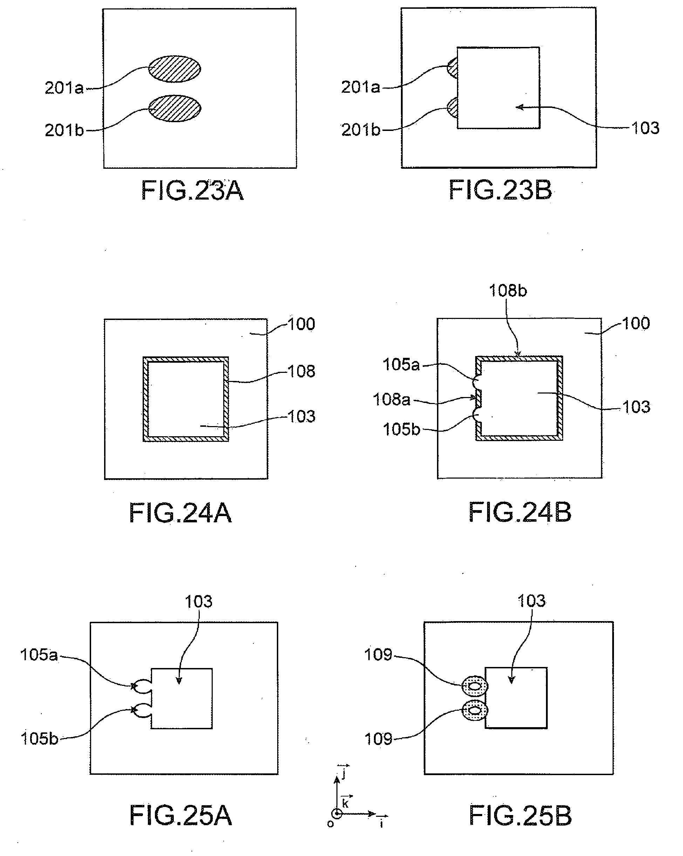

Dans l'exemple de procédé de réalisation des figures 23A-23B, on forme tout d'abord des plots conducteurs 201a, 201b de taille importante dans le support (figure 23A).

Puis, on forme une cavité 103 traversant le support 100 et une zone où se situe les plots conducteurs 201a, 201b, et de manière à entamer et retirer une portion importante de ces derniers et à conserver une autre portion contre un flanc de la cavité 103 (figure 23B).

Selon un autre exemple de procédé, on peut tout d'abord former une cavité 103 traversant un support 100, puis tapisser les parois de la cavité à l'aide d'une zone 108 de matériau conducteur (figure 24A).

Dans le cas où le support 100 est à base de matériau semi-conducteur, une couche isolante (non représentée) peut être préalablement déposée sur les parois verticales de la cavité.

On forme ensuite des rainures 105a, 105b, au niveau d'au moins une paroi verticale de la cavité, les rainures 105a, 105b communiquant avec la cavité 103.

Les rainures 105a, 105b sont réalisées de manière à retirer des portions de la zone 108 de matériau conducteur.

A l'issue de ce retrait une première zone conductrice 108a tapissant une partie des parois de la cavité 103 est séparée d'une deuxième zone conductrice 108b recouvrant une partie d'une paroi de la cavité 103, par l'intermédiaire des rainures 105a, 105b (figure 24B).

Selon un autre exemple de procédé, on forme dans un support 100, la cavité 103 et les rainures 105a, 105b, en même temps ou consécutivement (figure 25A).

Puis, on dépose une couche de matériau sacrificiel 109 dans les rainures 105a, 105b ou sur les parois des rainures 105a, 105b, le matériau sacrificiel 109 étant réparti de manière à former une séparation entre la cavité 103 et les rainures 105a, 105b (figure 25B).

La couche de matériau sacrificiel 109 peut être prévue de manière à dépasser dans la cavité 103.

Le matériau sacrificiel 109 peut être par exemple du SiO₂ ou du Si₃N₄.

Puis, on dépose une couche matériau conducteur 108 de manière à tapisser les parois de la cavité 103 et recouvrir le matériau sacrificiel 109.

Le matériau conducteur peut être déposé par exemple par PVD (PVD pour « Physical Vapour Deposition »).

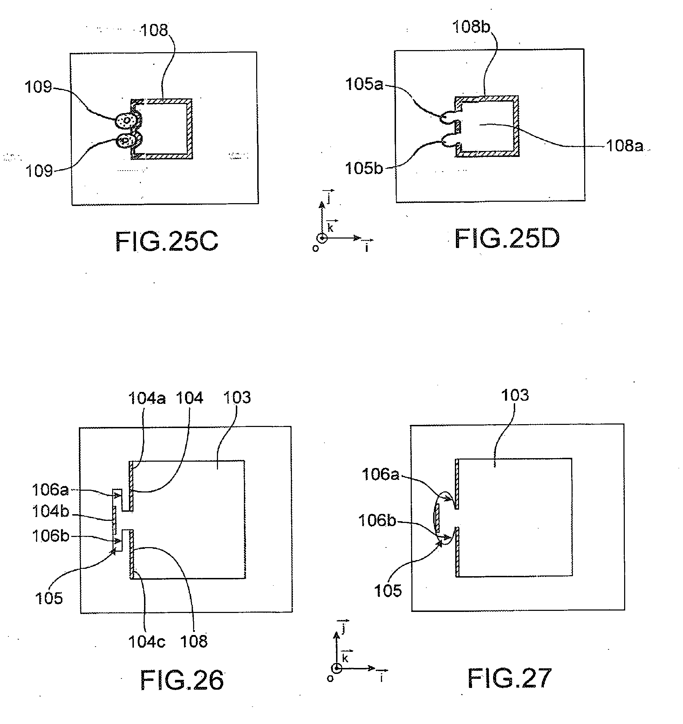

L'épaisseur de la couche de matériau conducteur 108 peut être prévue inférieure à l'épaisseur de la couche de matériau sacrificiel 109 dépassant dans la cavité 103 (figure 25C). On retire ensuite la couche de matériau sacrificiel 109, ce qui entraine un retrait du matériau conducteur 108 en regard des rainures 105a, 105b par exemple par gravure chimique humide.

A l'issue de ce retrait la zone conductrice 108 est sous forme de deux parties conductrices 108a et 108b distinctes qui ne sont pas connectées entre elles et sont séparées à l'aide des rainures 105a, 105b (figure 25D).

Un exemple de procédé de réalisation d'une structure d'interconnexion est donné sur les figures 26 et 27.

Dans cet exemple, on réalise dans un support 100, une cavité 103 traversant le support 100 ainsi qu'au moins une rainure 105 verticale s'étendant dans l'épaisseur du support 100, et communiquant avec la cavité 103.

La rainure peut avoir par exemple une section rectangulaire (figure 26) ou ovale (figure 27).

Des parties 106a, 106b, d'une paroi 104 de la cavité 103 forment une séparation entre cette dernière et la rainure 105.

On effectue ensuite un dépôt métallique 108 de manière à recouvrir une paroi de la cavité et sur une partie de la rainure 105. Les parties 106a, 106b empêchent d'effectuer un dépôt de métal tout autour de la rainure de sorte que le dépôt de métal sur la paroi 104 de la cavité et sur la rainure 105, forme une zone discontinue.

Le dépôt de métal peut être éventuellement un dépôt dit « directionnel » dans lequel le matériau est déposé selon un angle prédéterminé par rapport à une normale au plan principal du support (le plan principal du support étant un plan passant par ce dernier et parallèle au plan [o;*i̅*;*j̅*] du repère orthogonal [o;*i̅*;*j̅*;*k̅*] donné sur les figures).

Par effet d'ombrage, les parties 106a, 106b, empêchent un dépôt de métal sur le pourtour de la rainure.

On peut ainsi réaliser un élément de connexion 104b le long de la rainure, qui est déconnecté d'éléments conducteurs 104a et 104c formés sur ladite paroi lors du dépôt de métal.

Chacun des procédés ci-dessus peut être réalisé pour plusieurs substrats ou plusieurs couches qui sont ensuite assemblées. Lors de l'étape d'assemblage, on aligne les cavités obtenues dans les différents substrats ou les différentes couches, pour obtenir la cavité finale ayant la forme voulue. C'est notamment le cas, lorsque plusieurs cavités, de sections différentes sont superposées, comme pour les exemples décrits ci-dessus en liaison avec les figures 8A-C, 9A, 9B, 10A, 10B, etc.

On peut également réaliser un assemblage avant de mettre en oeuvre l'un ou l'autre de ces procédés, c'est notamment le cas lorsque le support final ne comporte que deux substrats ou deux couches assemblées ou superposées. Chacun des procédés ci-dessus peut alors être réalisé à partir de chaque face libre de l'assemblage.

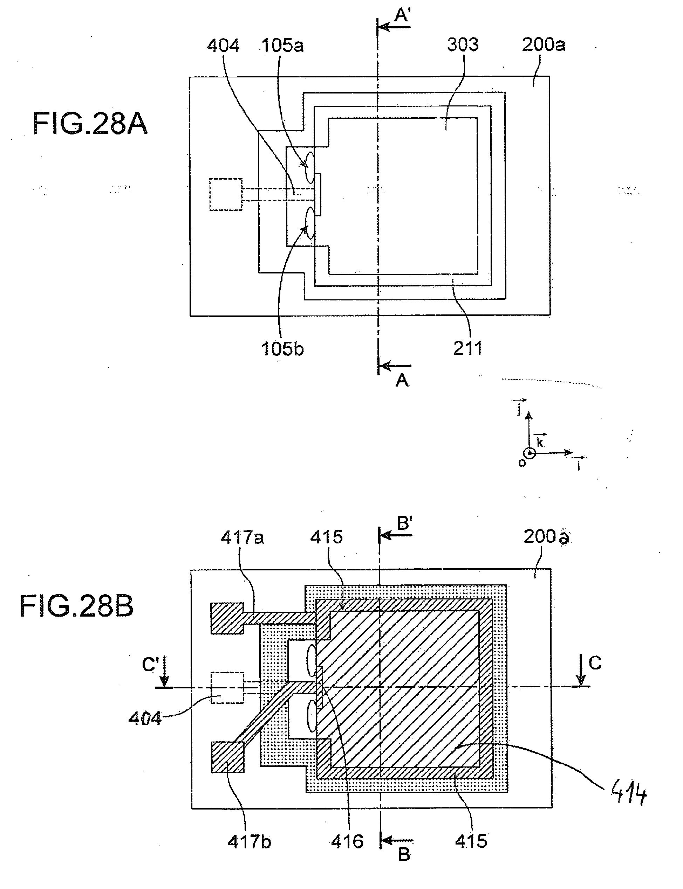

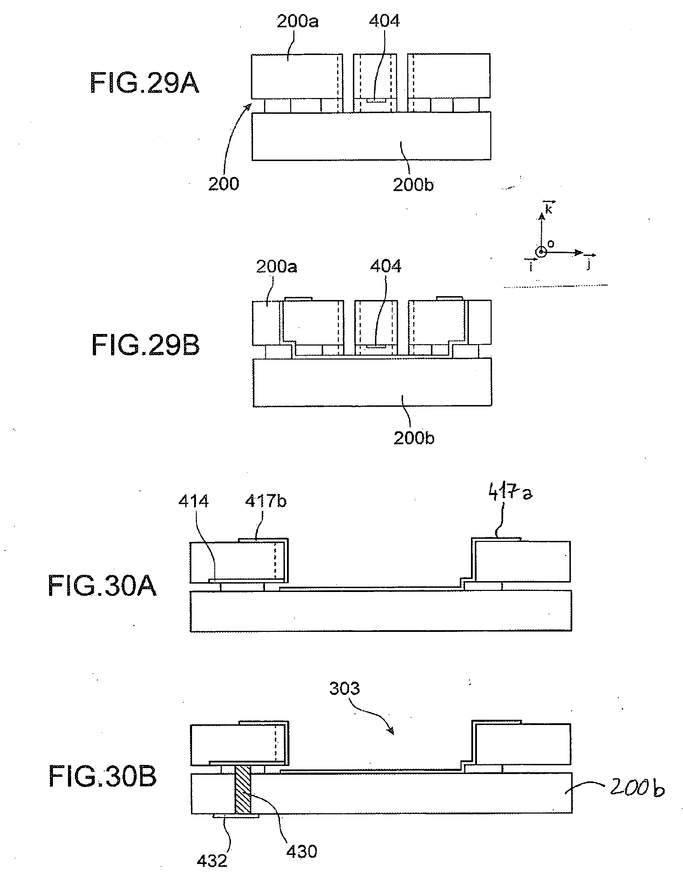

Un autre exemple de procédé de réalisation d'une structure d'interconnexion est donné sur les figures 28A-28B, et 29A-29B (les figures 28A-28B donnant une vue de dessus, tandis que les figures 29A-29B donnent une vue en coupe transversale dont le plan de coupe est indiqué sur les figures 28A-28B).

La structure d'interconnexion peut être réalisée à partir d'un support 200 qui peut être éventuellement formé de plusieurs couches ou de plusieurs substrats empilés, par exemple de deux couches 200a, 200b ou de deux substrats 200a, 200b, qui peuvent être assemblés par exemple par collage à l'aide d'un cordon de colle 211.

Une cavité 303 sous forme d'un orifice borgne est prévue dans le premier substrat 200a. Des rainures 105a, 105b, verticales, c'est-à-dire orthogonales au plan principal du support 200 ont été formées au niveau d'une paroi de la cavité et communiquent avec cette dernière. Des portions du cordon de colle 211 sont dévoilées par la cavité 303.

Dans cet exemple de réalisation, le premier substrat 200a comporte au moins une piste métallique 404 sur sa face arrière, c'est-à-dire la face située en regard du deuxième substrat 200b (figures 28A et 29A).

On effectue ensuite un dépôt de matériau sacrificiel dans les rainures 105a, 105b, puis un dépôt de matériau métallique 414 dans la cavité 303 et sur le support 200.

On retire ensuite le matériau sacrificiel, puis on forme des motifs dans le matériau métallique, par exemple une zone métallique 415 recouvrant des parois de la cavité 303, connectée à une piste métallique 417a sur la face supérieure du support.

Cette étape conduit également à la formation d'une autre zone métallique 416 séparée de la zone métallique 415 par l'intermédiaire des rainures 105a, 105b, la zone métallique 415 recouvre une portion de paroi de la cavité située entre les rainures 105a, 105b qui est prolongée par une autre piste métallique 417b formée sur la face supérieure du support (figures 28B et 29B).

La structure d'interconnexion a cavité qui vient d'être formée peut être intégrée ou assemblée avec un autre dispositif.

Sur les figures 30A-30E un exemple de procédé de réalisation d'un dispositif imageur comportant une telle structure d'interconnexion est donné.

Ce procédé peut être réalisé à partir de la structure formée précédemment (et décrite en liaison avec la figure 30A représentant le dispositif de la figure 28B selon une vue en coupe C'C).

On forme ensuite un ou plusieurs vias 430 traversant le deuxième support 200b ainsi qu'un ou des plots de connexion 432 sur ce support 200b, les plots 432 étant connectés aux vias 430(figure 30B).

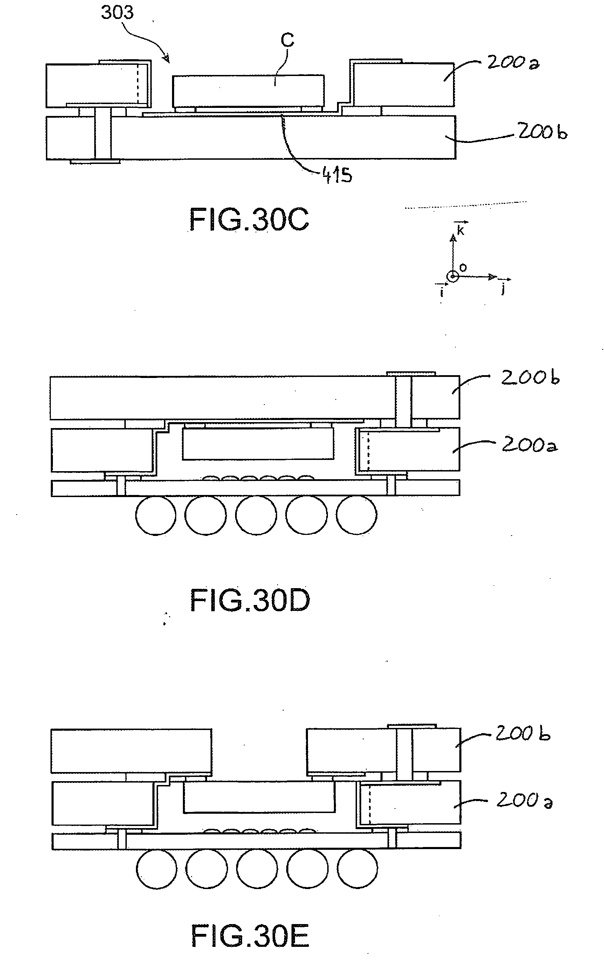

Un composant optique C, par exemple une lentille à focale fixe, une lame à faces parallèles ou encore un dispositif à focale variable est ensuite placé dans la cavité 303 et connecté à la zone conductrice 415 formée dans cette cavité (figure 30C).

Puis, on reporte un substrat imageur sur la face supérieure du premier substrat 200a, le substrat imageur étant assemblé et connecté aux pistes métalliques 417a, 417b formées sur la face supérieure du premier substrat 200a (figure 30D).

Ensuite, on réalise une ouverture dans le deuxième substrat 200b, en regard du composant optique C (figure 30E).

Une structure d'interconnexion à cavité telle que mise en oeuvre suivant l'invention, peut trouver des applications dans le domaine des composants MEMS, par exemple tels que les capteurs inertiels, accéléromètre ou gyromètre (figure 31).

La figure 32 montre un exemple de caméra unitaire constituée d'un élément optique actif 500 disposé sur le haut de la cavité 303, focalisé sur le substrat imageur.

Des remontées de contact sont mises en oeuvre dans une cavité 303 pour alimenter cet élément optique actif.

## Revendications

1. Dispositif d'interconnexion comprenant un support (200), formé de plusieurs substrats et/ou de plusieurs couches superposées (200a, 200b), comportant au moins un trou, le trou ayant des parois formant un contour fermé et étant formé d'une cavité (203) et d'une ou plusieurs rainures (205a-205h) communiquant avec ladite cavité (203), ladite cavité étant formée d'une première ouverture réalisée dans un premier substrat et/ou dans une première couche (200a) et d'une deuxième ouverture de section différente de la première ouverture réalisée dans un deuxième substrat et/ou dans une deuxième couche (200b), les rainures s'étendant tout ou partie le long du trou, plusieurs éléments conducteurs (307a-307h) étant disposés sur au moins une paroi du trou et traversant ce dernier, les éléments conducteurs étant destinés chacun à connecter entre elles des zones conductrices situées de part et d'autre du support (200) et les rainures (205a-205h) a assurer une discontinuité électrique entre les éléments conducteurs (307a-307h).

2. Dispositif d'interconnexion selon la revendication précédente, au moins une des dites rainures séparant entre eux deux desdits éléments conducteurs.

3. Dispositif d'interconnexion selon la revendication 1. ou 2, comportant axa moins un élément (218a, 218b) conducteur logé dans une desdites rainures (205a, 205b) et s'étendant en partie le long de ladite rainure.

4. Dispositif d'interconnexion selon la revendication précédente, au moins un élément conducteur (104b) recouvrant une portion seulement d'au moins une rainure (105), lesdites rainures assurant une discontinuité électrique (106a, 106b) entre les éléments de connexion dans les rainures (104b) et les éléments conducteurs dans la cavité (104a).

5. Dispositif d'interconnexion selon l'une des revendications précédentes, la cavité (203) traversant l'épaisseur du support (200).

6. Dispositif d'interconnexion selon l'une des revendications précédentes, la cavité (303) étant formée d'un orifice borgne réalisé dans le support (200).

7. Dispositif d'interconnexion selon l'une des revendications précédentes, lesdites rainures (205a-205h) communiquant avec ladite première ouverture (203a), une ou plusieurs autres rainures (215a-215h) formées dans le deuxième substrat (200b) le long de la cavité formée dans ledit substrat communiquant avec ladite ouverture (203b).

8. Dispositif d'interconnexion selon l'une des revendications précédentes, les parois de la cavité étant recouvertes de matériau conducteur.

9. Procédé de réalisation d'un dispositif d'interconnexion selon l'une quelconque des revendications 1 à 8, comprenant les étapes consistant pour chaque substrat et/ou chaque couche à:
a) former des plots conducteurs traversant ledit substrat ou ladite couche,
b) former une cavité dans l'épaisseur dudit substrat ou de ladite couche de manière à entamer et retirer une partie des plots conducteurs, l'autre partie des plots étant conservée et formant des éléments conducteurs (201a, 201b) logés dans des rainures (205a, 205b),
c) assembler, avant l'étape a) ou après l'étape b), les substrats et/ou les couches pour former le support (200).

10. Procédé de réalisation d'un dispositif d'interconnexion selon l'une quelconque des revendications 1 à 8, comprenant les étapes consistant pour chaque substrat et/ou couche à:
a) former une cavité dans l'épaisseur dudit substrat ou de ladite couche,
b) former une zone à base de matériau conducteur recouvrant les parois de la cavité,
c) former au moins une rainure de manière à entamer le matériau conducteur, la rainure communiquant avec la cavité,
d) assembler, avant l'étape a) ou après l'étape c), les substrats et/ou les couches pour former le support (200).

11. Procédé de réalisation d'un dispositif d'interconnexion selon l'une des revendications 1 à 8, comprenant les étapes consistant pour chaque substrat et/ou couche à :
a) former une cavité dans l'épaisseur dudit substrat ou de ladite couche des rainures communiquant avec ladite cavité et s'étendant sur tout ou partie de celle-ci,
b) former une couche de matériau sacrificiel dans les rainures, de manière à séparer les rainures de la cavité,
c) former une couche conductrice sur les parois de la cavité,
d) retirer la couche de matériau sacrificiel de manière à retirer des portions de la couche conductrice entre les rainures et la cavité,
e) assembler, avant l'étape a) ou après l'étape d), les substrats et/ou les couches pour former le support (200).

12. Procédé de réalisation d'un dispositif d'interconnexion selon l'une des revendications 1 à 8, comprenant les étapes consistant pour chaque substrat et/ou couche à :
a) former une cavité dans l'épaisseur dudit substrat ou de ladite couche,
b) former au moins une rainure communiquant avec ladite cavité et s'étendant sur tout ou partie de celle-ci, ladite rainure étant réalisé de sorte que dans un plan parallèle au support, une section variable avec un rétrécissement au niveau de la communication entre la rainure et la cavité,
c) réaliser un dépôt directionnel de matériau conducteur sur ladite paroi et sur une partie de la rainure,
d) assembler, avant l'étape a) ou après l'étape c), les substrats et/ou les couches pour former le support (200).

## Claims

1. An interconnect device comprising a support (200), formed by several superimpose substrates and/or layers (200a, 200b), in which at least one hole is formed, the hole having walls forming a closed contour and being formed by a cavity (203) and one or several slots (205a-205h) communicating with the cavity (203), the cavity is formed by a first opening made in a first substrate and/or in a first layer (200a) and a second opening with a different section from the first opening made in a second substrate and/or in a second layer (200b), the slots extending over all or part of the length of the hole, several conducting elements (307a-307h) being positioned on at least one wall of the hole and passing through the later part, the conducting elements each being intended to connect conducting areas to each other situated on either side of the support (200) and the slots (205a-205h) ensuring an electrical discontinuity between the conducting elements (307a-307h).

2. The interconnect device according to the preceding claim, at least one of said slots separating two of said conducting elements.

3. The interconnect device according to claim 1 or 2, comprising at least one conducting element (218a, (218b) housed in one of said slots (205a, 205b) and extending along said slot.

4. The interconnect device according to the preceding claim, at least on conductor element (104b) covering only a portion of at least a slot (105), the said slots ensuring an electrical discontinuity ( 106a, 106b) between the connecting elements in the slots (104b) and the conducting elements of the cavity (104a).

5. The interconnect device according to one of the preceding claims, the cavity (203) passing through the thickness of the support (200).

6. The interconnect device according to one of the preceding claims, the bottom of the cavity (303) is blind.

7. The interconnect device according to one of the preceding claims, said slots (205a-205h) communicating with said first opening (203a), one or several other slots (215a-21soh) formed in the second substrate (20 dub) along the cavity formed in said substrate communicating with the second opening (203b).

8. The interconnect device according to one of the preceding claims, the walls of the cavity being covered with conducting material.

9. A method for making an interconnect device according to any one of claims 1 to 8, comprising the steps consisting for each subtract and/or each layer :
a) forming conducting pads passing through the said subtract or said layer,
b) forming a cavity in the thickness of the said subtract or the said layer so as to open and remove part of the conducting pads, the other part of the pads being kept and forming conducting elements (201a, 201b) housed in grooves (205a, 205b),
c) gathering, before the step a) or after the step b), the subtracts and/or the layers to form the support (200).

10. A method for making an interconnect device according to any one of claims 1 to 8, comprising the steps consisting for each subtract and/or each layer:
a) forming a cavity in the thickness of the said subtract or said layer,
b) forming an area with a conducting base covering the walls of the cavity,
c) forming at least one slot so as to open the conducting material, the slot communicating with the cavity,
d) gathering, before the step a) or after the step c), the subtracts and/or the layers to form the support (200).

11. A method for making an interconnect device according to one of claims 1 to 8, comprising the steps consisting for each subtract and/or each layer:
a) forming a cavity in the thickness of the said subtract or said layer, slots communicating with said cavity and extending over all or part thereof,
b) forming a layer of sacrificial material in the slots, so as to separate the slots from the cavity,
c) forming a conducting layer on the walls of the cavity,
d) removing the layer of sacrificial material so as to remove portions of the conducting layer between the slots and the cavity,
e) gathering, before the step a) or after the step d), the subtracts and/or the layers to form the support (200).

12. A method for making an interconnect device according to one of claims 1 to 8, comprising the steps consisting for each subtract ard/or each layer:
a) forming a cavity in the thickness s of the said subtract or said layer,
b) forming at least one slot communicating with said cavity and extending over all or part thereof, said slot being made such that it has, in a plane parallel to the support, a variable section with a narrowing at the connection between the slot and the cavity,
c) performing a directional deposition of conducting material on said wall and on part of the slot,
d) gathering, before the step a) or after the step c), the subtracts and/or the layers to form the support (200).

## Patentansprüche

1. Verbindungsvorrichtung umfassend einen Träger (200), der aus mehreren Substraten und/oder mehreren, über einander liegenden Schichten (200a, 200 b) gebildet ist, die wenigstens ein Loch umfassen, wobei das Loch Wände aufweist, die einen geschlossenen Umriss bilden und durch einen Hohlraum (203) und eine oder mehrere Nute (205a-205h), die mit dem Hohlraum (203) in Verbindung stehen, gebildet werden, wobei dieser Hohlraum durch eine in einem ersten Substrat und/oder in einer ersten Schicht (200a) ausgeführte erste Öffnung und durch eine in einem zweiten Substrat und/oder in einer zweiten Schicht (200b) ausgeführte zweite Öffnung mit einem zur ersten Öffnung verschiedenen Querschnitt gebildet wird, die Nute sich über die gesamte oder einen Teil der Länge des Lochs erstrecken, mehrere Leiterelemente (307a-307h) auf wenigstens einer Wand des Lochs angeordnet sind und letzteres durchqueren und die Leiterelemente jeweils dazu bestimmt sind, auf beiden Seiten des Trägers (200) befindliche Leiterbereiche und die Nute (205a-205h) mit einander zu verbinden, um eine elektrische Unterbrechung zwischen den Leiterelementen (307a-307h) zu gewährleisten.

2. Verbindungsvorrichtung gemäß dem vorangehenden Anspruch, wobei wenigstens eine dieser Nute zwei dieser Leiterelemente von einander trennt.

3. Verbindungsvorrichtung gemäß Anspruch 1 oder 2, die wenigstens ein Leiterelement (2la, 218b) umfasst, das sich in einer der Nute (205a, 205b) befindet und sich zum Teil entlang dieser Nut erstreckt.

4. Verbindungsvorrichtung gemäß dem vorangehenden Anspruch, wobei wenigstens ein Leiterelement (1 04b) nur einen Teil wenigstens einer Nut (105) bedeckt und die Nute eine elektrische Unterbrechung (106a, 106b) zwischen den Verbindunrgselementen in den Nuten (104b) und den Leiterelementen in dem Hohlraum (104a) gewährleisten.

5. Verbindungsvorrichtung gemäß einem der vorangehenden Ansprüche, wobei der Hohlraum (203) die Dicke des Trägers (200) durchquert.

6. Verbindungsvorrichtung gemäß einem der vorangehenden Ansprüche, wobei der Hohlraum (303) durch ein in dem Träger (200) ausgeführtes Sackloch gebildet wird.

7. Verbindungsvorrichtung gemäß einem der vorangehenden Ansprüche, wobei die Nute (205a-205h) mit der ersten Öffnung (203a) in Verbindung stehen und eine oder mehrere andere, in dem zweiten Substrat (200b) entlang des in diesem Substrat gebildeten Hohlraums gebildete Nute (215a-215h) mit der Öffnung (203b) in Verbindung stehen.

8. Verbindungsvorrichtung gemäß einem der vorangehenden Ansprüche, wobei die Wände des Hohlraums mit Leitermaterial überzogen sind.

9. Verfahren zur Herstellung einer Verbindungsvorrichtung gemäß einem der Ansprüche 1 bis 8, das die Schritte umfasst, die für jedes Substrat und/oder jede Schicht aus Folgendem bestehen:
a) Bilden das Substrat oder die Schicht durchquerender Kontakte,
b) Bilden eines Hohlraums in der Dicke des Substrats oder der Schicht, so dass ein Teil der Kontakte aufgebrochen und entfernt wird, wobei der andere Teil der Kontakte beibehalten wird und in den Nuten 05a, 205b) befindliche Leiterelemente (201 a, 201 b) bildet,
c) nach dem Schritt a) oder nach dem Schritt b) Zusammenfügen der Substrate und/oder Schichten zum Bilden des Trägers (200).

10. Verfahren zur Herstellung einer Verbindungsvorrichtung gemäß einem der Ansprüche 1 bis 8, das die Schritte umfasst, die für jedes Substrat und/oder jede Schicht aus Folgendem bestehen:
a) Bilden eines Hohlraums in der Dicke des Substrats oder der Schicht,
b) Bilden eines Bereiches aus Leitermaterial, das die Wände des Hohlraums bedeckt,
c) Bilden wenigstens einer Nut, so dass das Leitermaterial aufgebrochen wird und die Nut mit dem Hohlraum in Verbindung steht,
d) nach dem Schritt a) oder nach dem Schritt c) Zusammenfügen der Substrate und/oder Schichten zum Bilden des Trägers (200).

11. Verfahren zur Herstellung einer Verbindungsvorrichtung gemäß einem der Ansprüche 1 bis 8, das die Schritte umfasst, die für jedes Substrat und/oder jede Schicht aus Folgendem bestehen:
a) Bilden eines Hohlraums in der Dicke des Substrats oder der Schicht und Nuten, die mit dem Hohlraum in Verbindung stehen und sich überall oder über einen Teil von ihm erstrecken,
b) Bilden einer Schicht aus Opfermaterial in den Nuten, so dass die Nute von dem Hohlraum getrennt werden,
c) Bilden einer leitenden Schicht auf den Wänden des Hohlraums,
d) Entfernen der Schicht aus Opfermaterial, so dass Teile der leitenden Schicht zwischen den Nuten und dem Hohlraum entfernt werden,
e) nach dem Schritt a) oder nach dem Schritt d) Zusammenfügen der Substrate und/oder Schichten zum Bilden des Trägers (200).

12. Verfahren zur Herstellung einer Verbindungsvorrichtung gemäß einem der Ansprüche 1 bis 8, das die Schritte umfasst, die für jedes Substrat und/oder jede Schicht aus Folgendem bestehen:
a) Bilden eines Hohlraums in der Dicke des Substrats oder der Schicht,
b) Bilden wenigstens einer Nut, die mit dem Hohlraum in Verbindung steht und sich überall oder über einen Teil von ihm erstreckt, wobei die Nut so ausgeführt wird, dass sie in einer Ebene parallel zu dem Träger einen veränderlichen Querschnitt mit einer Einengung an der Verbindung zwischen der Nut und dem Hohlraum aufweist,
c) Ausführen eines gerichteten Auftrags von Leitermaterial auf die Wand und auf einen Teil der Nut,
d) nach dem Schritt a) oder nach dem Schritt c) Zusammenfügen der Substrate und/oder Schichten zum Bilden des Trägers (200).
